# EUROPEAN PATENT APPLICATION

(11) **EP 4 478 427 A1**
(43) Date of publication of application: **18.12.2024**
(21) Application number: 23461604.3
(22) Date of filing: 15.06.2023
(51) Int. Cl.: H01L 31/0352, H01L 31/0232, H01L 31/032, H01L 31/09, H01L 31/103, H01L 31/18, H01L 33/06, H01L 33/24, H01L 33/28, G01J 3/12

(54) **ACTIVE PHOTOELECTRIC ELEMENT, METHOD OF GENERATION OF RADIATION AND METHOD OF DETECTION OF RADIATION**

(71) Applicant: Instytut Fizyki Polskiej Akademii Nauk, 02-668 Warszawa (PL)
(72) Inventor: Szot, Michal, 02-668 Warszawa (PL); Wolkanowicz, Wojciech, 02-668 Warszawa (PL); Chusnutdinow, Sergij, 02-668 Warszawa (PL); Karczewski, Grzegorz, 02-668 Warszawa (PL); Story, Tomasz, 02-668 Warszawa (PL)
(74) Representative: Bury & Bury

(57) **Abstract**

Active photoelectric element having layered structure stacked along a first axis and comprising a first electrode **(141)** and a second electrode **(142).** A layer of lead telluride **(130)** disposed between two layers of cadmium telluride **(121, 122)** is an active layer. The first electrode **(141)** is connected to the second layer of cadmium telluride **(121).** The layer of lead telluride **(130)** has a thickness varying along at least one axis perpendicular to the first axis and at least one of the first and the second electrodes **(141,142)** extends along said at least one axis.

## Description

### Field of the invention

The invention concerns active photoelectric element, method of generation of radiation and method of detection of radiation.

### State of the art

Detectors of electromagnetic radiation in the mid-infrared range are optical devices that are widely used in environmental protection, medical diagnostics, defense and broadly understood industry, e.g. to support production processes.

Typically, thermocouples or semiconductor devices based on narrow-gap materials such as PbTe, PbSe, PbS, PbSnTe, InSb, InAs, HgCdTe are used for infrared detection. Thermocouples, as they are much slower (response time of the order of ms), are not used in devices requiring fast signal processing, such as thermal imaging cameras.

Modern applications require sensitive detectors with response times of ns, which are achievable with semiconductor structures. The range of the highest sensitivity of semiconductor devices is determined by the width of the energy gap of the material, which, for example in the case of Lead Telluride (PbTe), is about 0.3 eV at room temperature (300 K). Simultaneously, the sensitivity of semiconductor detectors is usually inversely proportional to the spectral range of its operation, and in the case of materials with a narrow bandgap it is additionally strongly limited by the processes of non-radiative recombination of photo-excited current carriers. This is due to the fact that the energies of optical transitions in the case of narrow gap materials begin to be comparable to the energies characteristic of Auger processes responsible for non-radiative relaxation of excited carriers. In turn, enhancement of the sensitivity can be achieved by building detectors based on quantum structures such as quantum wells (QWs) made of multilayers of semiconductors with a narrow and wide band gap. In such a structure, the material with a narrow gap constitutes the area of the quantum well, in which carriers, excited by electromagnetic radiation, are located and the material with a wide gap constitutes the area of the energy barrier.

The use of structures containing one or more quantum wells for detection allows to limit the influence of Auger processes on the performance of the device, because in wide-gap materials the role of these processes is much weaker (see Y. Jiang, M. C. Teich, and W. I. Wang, Appl. Phys. Lett. 57, 2922 (1990); Y. Jiang, M. C. Teich, and W. I. Wang, J. Appl. Phys. 69, 6869 (1991)), as shown for the material systems InAs/GaInSb (J. R. Meyer, C. L. Felix, W. W. Bewley, I. Vurgaftman, ... et. al, Appl. Phys. Lett. 73, 2857 (1998); C. H. Grein, P. M. Young, M. E. Flatte, H. Ehrenreich, J. Appl. Phys. 78, 7143 (1995); C. Mailhiot and D. L. Smith, J. Vat. Sci. Technol. A7, 445 (1989); D. H. Chow, R. H. Miles, J. N. Schulman, D.A. Collins, andT. C. McGill, Semicond. Sci. Technol. 6, C47 (1991)), HgCdTe/CdTe (Y. Jiang, M. C. Teich, and W. I. Wang, J. Appl. Phys. 69, 6869 (1991)), PbSe/CdTe (S. Chusnutdinow, M. Szot, T. Wojtowicz, and G. Karczewski, AIP Advances 7 (3), 035111 (2017), PbSe/CdS (B. B. Weng, J. J. Qiu, L. H. Zhao, C. Chang, and Z. S. Shi, Appl. Phys. Lett. 104, 121111 (2014)).

An additional benefit of such a quantum structure is the increased occupancy of electronic levels, which translates into an increase in the operating temperature of the detector, even to room temperature - available detectors require cooling (with use of liquid nitrogen or thermoelectric coolers) in order to ensure the appropriate amount of carriers at electronic levels, to guarantee the useful sensitivity of the detector.

The depth of the quantum well U in a multilayer heterostructure depends on the difference in the energy of the band gaps Eg1 and Eg2 of the pair of semiconductors and on the distribution of this difference in the conduction and valence bands, characterized by the, so-called, band-offset. The width of the quantum well d is directly related to the thickness of the semiconductor layer constituting the quantum well area. Both parameters can therefore be controlled by selecting the materials, from which the heterostructure will be made - controlling the depth of the quantum well, and by monitoring the structure growth process - controlling the width of the quantum well.

It has recently been shown that a pair of materials - narrow band gap PbTe and wide band gap Cadmium Telluride (CdTe) - form a semiconductor heterosystem showing very high sensitivity to infrared radiation (S. Chusnutdinow, S. Schreyeck, S. Kret, A. Kazakov, and G. Karczewski, Appl. Phys. Lett. 117, 072102 (2020),Polish patent application no PL434623). The large difference in the energy gaps of both semiconductors (Eg(PbTe) = 0.3 eV, Eg(CdTe) = 1.5 eV at T=300K) results in the formation of a very deep potential well of about 1 eV in the conduction band. Moreover, both semiconductors crystallize in different crystal structures - PbTe in the rock-salt structure and CdTe in the structure of zinc blende. This difference causes a practical lack of mutual solubility of both semiconductors at temperatures up to 500°C, which on the one hand ensures high quality of multilayers made of them (G. Karczewski, M. Szot, S. Kret, L. Kowalczyk, S. Chusnutdinow, T. Wojtowicz, S. Schreyeck, K. Brunner, C. Schumacher, and L. W. Molenkamp, Nanotechnology 26, 135601 (2015)), and on the other hand results in the appearance of a large number of broken electron bonds on PbTe/CdTe interfaces. These bonds are saturated by capturing electrons from the PbTe layers, effectively reducing the value of the dark current of the detector. This effect, combined with the favorable arrangement of bands in the PbTe/CdTe heterostructure (large quantum confinement), is responsible for the high photosensitivity of PbTe/CdTe structures even at room temperature. At the same time, thanks to the extremely large quantum confinement, PbTe/CdTe heterostructures have been successfully used to obtain infrared laser emission in VECSEL type lasers (A. Khiar, V. Volobuev, M. Witzan, A. Hochreiner, M. Eibelhuber, and G. Springholz, Appl. Phys. Lett. 104, 231105 (2014)).

Generally in layered structures active layers are layers in which absorbing and/or generating radiation takes place.

The use of a quantum structure in the active region of the detector permits also for a change in the spectral sensitivity range of the device in relation to the case, when it is made on the basis of the same material in a bulk form. It is because the allowed carrier energies in the quantum well area are increased relative to the band gap energy of the bulk material by energy resulting from spatial confinement. The value of this extra energy depends on the depth and width of the quantum well and on the material it is made of (via the effective mass of carriers in the semiconductor) (Leonard L. Schiff, Quantum mechanics, 3rd edition, McGraw-Hill Education; 3Rev Ed edition (January 1, 1968)). A large number of degrees of freedom and the relative ease of changing the key parameters of the quantum structure (e.g. using the molecular beam epitaxy technique to produce these structures) resulted in the appearance of detectors and emitters of electromagnetic radiation with a cascade arrangement of quantum wells in the active region of the device (Quantum Cascade Detectors), i.e. grown one above the other (L. Gendron, M. Carras, A. Huynh, and V. Ortiz, C. Koeniguer and V. Berger, Appl. Phys. Lett. 85, 231105 (2004); A. Rogalski, Infrared Phys. Technol. 43, 187 (2002); A. Rogalski, Progress in Quantum Electronics 27, 59 (2003)).

Cascade-type structures contain from a few to several identical quantum wells or wells that differ in width or/and depth. Such a solution allows, among others, to extend the range of spectral sensitivity of the detector or selective absorption of radiation depending on the choice of quantum well parameters. In the first case, obtaining a quasi-continuous spectrum of detector sensitivity involves the need to create a large number of quantum wells in the structure with very well controlled parameters, which slightly differ between the wells. In the second case, the selectivity of the detector sensitivity results from the presence in the active region of the device of one or several types of quantum wells with significantly different parameters. In QCD structures, changes in the parameters of quantum wells, and thus changes in the energy of available electron transition energies in these wells, occur in the direction of structure growth, i.e. in the direction perpendicular to the plane of the detector.

Changes in the parameters U and d of the quantum wells can be obtained by:
- changing the thickness of subsequent layers forming the QW area, maintaining a constant thickness of the layers forming the QB area. In this case, the shift of the energy levels in the quantum well is achieved without changing the energy gap of the individual materials.
- changing the chemical composition of individual layers (while maintaining the thickness of the layers) by appropriately alloying the base semiconductors with other elements that change the value of their energy gaps and thus change the depth or shape of the quantum well profile, resulting in a change in the arrangement of electron levels in the entire structure.

Advantages of use of quantum well and their limitation apply *mutatis mutandis* to structures generating radiation as in these kind of structures detection and generation of radiation in photoelectronic elements are based on the same physical principles.

EP2801115 discloses a photodetector for infrared light radiation having a given wavelength, including a stack of layers forming a layered structure. The layered structure comprises a continuous active layer of a partially absorbent semiconductor material e.g. PbTe, which constitutes the active (photodetection) area. The structure further comprises a spacer layer of a material that is transparent to given wavelength and a structured metal mirror. The mirror surface has a profile corresponding to the periodic repetition, according to period (P), of a basic pattern defined by the alternating series of raised surfaces of PbTe and CdTe.

Main problem related to photoelectric elements - such as devices comprising structures for generation and detection of radiation taking benefit of quantum wells - is that they are tuned to single wavelength and cannot work in wider spectrum.

### Problem to be solved

The aim of the invention is to solve a problem of providing an effective structure of photoelectric active element adapted for generation or detection of light at a spectrum of wavelengths especially a tunable photoelectric, active element, operable without a need of use of high voltages, allowing to obtain electrical field of few tens of kV/cm.

### Summary of the invention

The invention concerns an active photoelectric element having layered structure stacked along a first axis and comprising a first electrode and a second electrode. The layered structure comprises a substrate and a structure of quantum well. The structure of the quantum well comprises a first layer of cadmium telluride, a second layer of cadmium telluride and a layer of lead telluride disposed between the first layer of cadmium telluride and the second layer of cadmium telluride. The layer of lead telluride is an active layer. The first electrode is connected to the second layer of cadmium telluride. The layer of lead telluride has a thickness varying along at least one axis perpendicular to the first axis and at least one of the first and the second electrodes extends along said at least one axis. Varying thickness of lead telluride layer allows a use of photoelectric effect in a wide frequency band or wavelength range. It has a synergy with selection of materials. Combining the lead telluride and cadmium telluride allows using wavelength up to range of 0.775 um to 6.5 um depending of the maximal and minimal thickness of the active lead telluride layer.

The active photoelectric element, advantageously, comprises selective optical element adapted to focus incident radiation on an area of the second layer of cadmium telluride, corresponding to different widths of the layer of lead telluride disposed below the area or is adapted to direct radiation originating from the layer lead telluride below the area to predefined direction. Use of optic element allows selecting a particular wavelength for operation of detection or generation of light. Said wavelength depends on the width of the lead telluride being in the focus of the selective optical element.

Advantageously, the selective optical element is a lens focused on the second cadmium telluride layer.

Advantageously, the second electrode is connected to the layer of lead telluride, so that the photoelectric element is adapted for detection of radiation.

Advantageously the first layer of cadmium telluride is doped with dopant causing first type of semicoductivity and the second layer of cadmium telluride is doped with dopant causing opposite type of semiconductivity. The second electrode is connected to the first layer of cadmium telluride, so that the photoelectric element works as a diode adapted for generation of radiation.

In a method of generation of radiation, according to the invention, radiation is generated by applying voltage to contacts of the phototelectric element, according to the invention.

In a method of detection radiation, according to the invention, the photoelectric element, according to the invention, is exposed to radiation and contacts are used to read result of detection.

### Description of drawings

The invention has been described below in detail, with reference to the following figures.
Fig. 1 shows schematically a cross section of the layered structure in an embodiment of the invention.
Fig. 2a shows schematically another orthogonal cross-section of the layered structure in an embodiment of the invention shown in Fig. 1 with contacts arrangement adapted to detection of light.
Fig. 2b shows schematically orthogonal cross-section of the layered structure in an another embodiment of the invention with contacts arrangement adapted to generation of light.
Fig. 3 shows schematically a top view of the layered structure of the same embodiment.
Fig. 4 shows schematically a cross-section of layered structure of embodiment of the invention with a lens movable in parallel to the layered structure.

### Embodiments of the invention

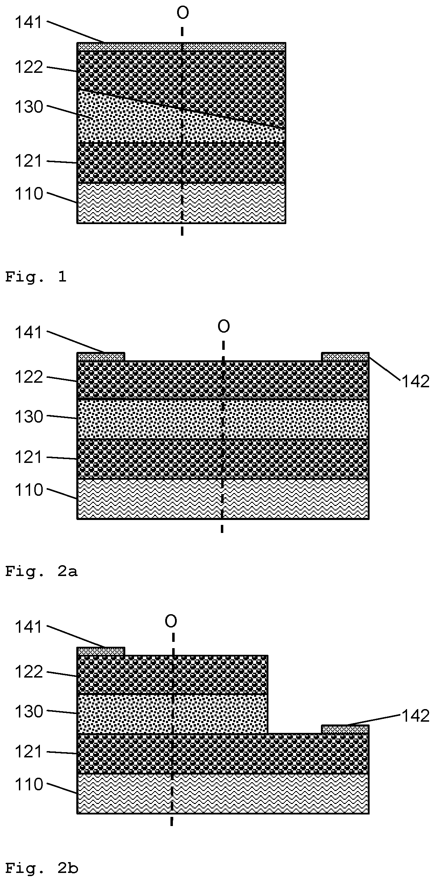

Fig. 1 shows cross section of a structure applied in the detector, according to an embodiment of the present invention. The structure has been manufactured in subsequent steps described below.

First, a 4 µm thick first layer of cadmium telluride 121 has been grown on a commercially available (100) oriented epi-ready GaAs substrate **110** at 300°C in a 5h long process using separate effusion cells for Cd and Te elements with a purity of N5 (99.9990). The first layer **121** is a CdTe buffer layer.

Subsequently, a 10 nm thick PbTe layer **130** was grown for 2 minutes at 270°C on the first CdTe layer **121** acting as buffer. The PbTe layer **130** was obtained using separate effusion cells for Pb and Te elements. Then initial 10 nm thick layer of PbTe is grown. Subsequently, the PbTe layer **130** has been grown for 5 minutes at the same temperature, so that addtional thickness of the PbTe layer **130** is linearly varying in the plane of the structure from 0 nm to 25 nm - as shown in Fig. 1. This effect has been obtained with a movable shutter applied during the process. During the growth of this PbTe layer, the movable shutter placed in the path of atomic beams, just above the structure, moved over a length of 10 mm at a constant speed of 50 pm/s from one edge of the substrate to the other. PbTe layer **130** is an active layer. Its total width varies from 10 nm to 35 nm.

Subsequently, a second layer of CdTe **122** was grown. The layer has thickness of 200 nm and was grown for 40 minutes at temperature 300 °C. Lowering the temperature during the PbTe deposition prevented the decomposition of PbTe layers into nano-grains. The ratio of molecular fluxes of Cd and Te as well as Pb and Te elements during the growth of individual layers was maintained at 1:1 with beam equivalent pressure for all used elements of 3 × 10⁻⁷ mbar. A shape complementary to the of prism of the active layer has been obtained with moving shutter. The longer area is exposed to beam without the shutter and the thicker the layer is. Accordingly a stack of layers along the first axis **O** was obtained.

The second CdTe layer **122** has one dimension shorter than the PbTe layer **130** as shown on the right side of in Fig. 2a. The margin is meant for applying a second contact **142.** This configuration is adapted for detection of radiation.

In the next steps a first contact **141** and the second contact **142** are applied. The contact **142** extends along said axis, along which thickness of the PbTe layer **130** is varying.

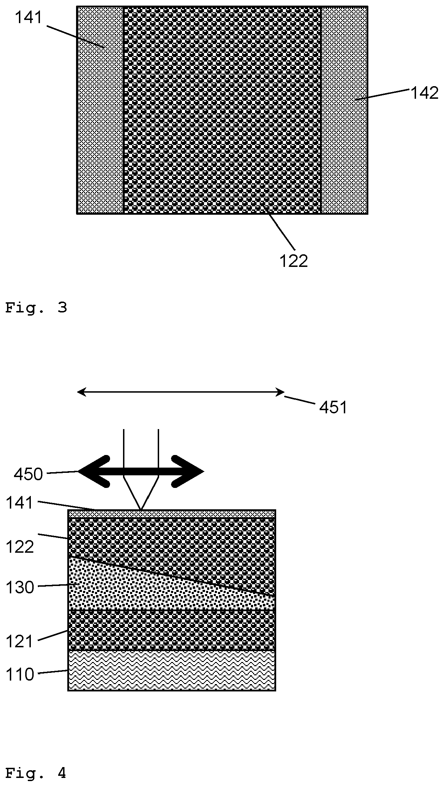

In the present embodiment, the first contact **141** runs in parallel with contact **142,** as shown in Fig. 3. There are many ways of distributing the contacts, however it is important to provide area that can be subjected to radiation and varying thickness of active PbTe layer **130** between them.

Accordingly an active area of the detector, according to this embodiment, contains a single wedge-shaped quantum well made of PbTe and CdTe semiconductors with a variable width as shown in Fig. 1. This geometry and selection of materials allows to exploit the benefits of quantum effects in the absence of disadvantages resulting from the cascading arrangement of many quantum wells in the device.

The wide spectral range of sensitivity here is the result of changing the width of the quantum well in the detector plane. The proposed layout of the detector structure ensures the same penetration of electromagnetic radiation into the different areas of the quantum well sensitive to particular wavelengths of radiation. Thus, the invention can be used for sensing in a wide spectrum. Total width of active PbTe layer **130** varies from 10 nm to 35 nm. This corresponds to radiation of wavelength in range from 3 um to 5 µm. Lower limit of the corresponding radiation can be reduced if the width of initial layer of PbTe is reduced. Minimal obtainable wavelength corresponds to barrier of CdTe, 1.6 eV and is approximately 775 nm. Upper limit is determined by width of the thicker end of the active PbTe layer **130.** Maximum is determined by the depth of the quantum well, which for PbTe/CdTe is c.a. 0.19 eV in cryogenic temperatures.

Additional improvement to the invention is based on selective choice of individual wavelengths. It is possible by focusing the electromagnetic radiation having specific wavelength at a specific place of the detector area by means of movable optical element as shown in Fig. 4. It is therefore not necessary to use additional, selective filters or resonators, and the change in the sensitivity range is obtained within one quantum well.

In the present embodiment, the movable optical element was a lens **450** focused on the detecting structure with a mechanism for positioning horizontally along line **451.** A shift of the lens along the gradient of thickness

The wedge-shaped PbTe/CdTe quantum structure discussed above was used in the configuration of a photo-resistor with electrical contacts **141, 142** provided on the edges of the structure along which the width of the quantum well changes (see Fig. 2 and 3). Such arrangement of contacts ensures a simultaneous electrical connection with the areas of the photodetector structure sensitive to infrared radiation of different wavelengths.

In a particular case, the radiation focused in a given place of the PbTe quantum wedge excites locally trapped electrons to available electrical levels, the energy of which results from the thickness of the wedge in a given place. If the energy of photons incident on the detector corresponds to the energy of local quantum electrical levels, photo-excited electrons can participate in electron transport, lowering the electrical resistance of the detector. In the case of the proposed solution, the transport of electrons takes place in the plane of the quantum well, so, unlike detectors with a cascade arrangement of quantum wells, there is no need to use high voltages to facilitate the access of photo-excited carriers to the electrical contact zones. Electrical field of c.a 30 V/cm proved to be sufficient. Easiest configuration of detector is to use a circuit with known resistance inserted in series with the active photonic element, according to the invention, apply the voltage to the circuit and observe voltage on the known resistor as it depends on the current, which in turn depends on the resistance of the photonic element, which changes with applied radiation.

The wedge-shaped structure, according to the invention and contact structure can be used for light generation. It allows generation of whole spectrum of light in a range of wavelength from 0.775 um to 6.5 µm.

It is noted that the structure presented above and the contact can be used to generate light in desired spectrum. It requires additional doping to obtain diode structure and different arrangement of electrodes, specifically the second electrode 142 as shown in Fig. 2b.

The first layer of cadmium telluride **121** is doped with dopant, causing n-type of conductivity, e.g. Iodine or Indium, or complex thereof. The second layer of cadmium telluride **122** doped with dopant causing opposite - p-type of semiconductivity - e.g. Cupper, Phosphorus or Nitrogen or complex thereof. The second electrode **142** is connected to the first layer of cadmium telluride **121,** so that the photoelectric element is adapted for generation of radiation.

Profile of thickness of the PbTe layer can be adapted to desired spectral composition of radiation. For example a light of desired "temperature" can be obtained.

Use of movable lens in a light generating structure allows selection of a wavelength radiation that is going to be directed outwards from the structure and therefore to select color.

In conclusion, it should be understood that the embodiments of the detector and light generation structure discussed throughout this patent description are provided by way of example and not intended to limit the scope of the invention. The described embodiments are merely illustrative of the principles of the invention and serve to facilitate a comprehensive understanding of its features and functionalities.

A person skilled in the art, after studying and assimilating the teachings of this invention, will recognize the versatility and adaptability of the disclosed concepts. With this knowledge, they will be able to propose various profiles of the PbTe layer that are suitable for different applications and requirements. The invention encompasses the use of alternative designs, configurations, and materials, all falling within the scope of the appended claims.

Moreover, it is important to note that the manufacturing techniques and processes described herein are not intended to be limiting. Those skilled in the art are well aware of various methods and approaches for fabricating such structures, and the invention is not restricted to any specific manufacturing technique. Well-established techniques commonly used in the field can be employed to produce the detector and light generation structures with the desired characteristics.
In conclusion, the described embodiments and the various alternatives and modifications apparent to those skilled in the art are intended to be encompassed within the scope of the invention as defined by the appended claims. The invention opens up a vast array of possibilities for designing and implementing detector and light generation structures for diverse applications, allowing for advancements and improvements in the field of photoelectric elements.

## Claims

1. Active photoelectric element having layered structure stacked along a first axis (**O**) and comprising a first electrode (**141**) and a second electrode (**142**), wherein the layered structure, comprising
a substrate (**110**) and
a structure of quantum well, comprising
a first layer of cadmium telluride (**121**)
a second layer of cadmium telluride (**122**)
a layer of lead telluride (**130**) disposed between
the first layer of cadmium telluride (**121**) and the second layer of cadmium telluride (**122**),
wherein
the layer of lead telluride (**130**) is an active layer and the first electrode (**141**) is connected to the second layer of cadmium telluride (**122**),
**characterized in that**
the layer of lead telluride (**130**) has a thickness varying along at least one axis, perpendicular to the first axis (**O**) and at least one of the first and the second electrodes (**141**,**142**) extends along said at least one axis.

2. Active photoelectric element, according to claim 1, comprising a selective optical element (**450**) adapted to focus incident radiation on an area of the second layer of cadmium telluride (**122**), corresponding to different widths of the layer of lead telluride (**130**), disposed below the area, or is adapted to direct radiation originating from the active layer below the area to predefined direction (**451**).

3. Active photoelectric element, according to claim 2, wherein the selective optical element is a lens (**450**) focused on the second cadmium telluride layer (**122**).

4. Active photoelectric element, according to any of claims 1 to 3, wherein the second electrode (**142**) is connected to the layer of lead telluride (**130**), so that the photoelectric element is adapted for detection of radiation.

5. Active photoelectric element, according to any of claims 1 to 3, wherein
the first layer of cadmium telluride (**121**) doped with dopant, causing first type of semicoductivity
the second layer of cadmium telluride (**122**) doped with dopant, causing opposite type of semiconductivity and
the second electrode (**142**) is connected to the first layer of cadmium telluride (1**21**), so that the photoelectric element is adapted for generation of radiation.

6. A method of generating radiation with active photoelectric element, **characterized in that** radiation is generated by applying voltage to contacts (**141**), (**142**) of the phototelectric element, as defined in claim 5.

7. A method of detection of radiation with active photoelectric element, **characterized in that** a radiation element, as defined in claim 4, is exposed to radiation and contacts (**141**), (**142**) are used to read result of detection.
